# EUROPEAN PATENT APPLICATION

(11) **EP 4 567 803 A1**
(43) Date of publication of application: **11.06.2025**
(21) Application number: 23315216.4
(22) Date of filing: 24.05.2023
(51) Int. Cl.: G11C 11/16

(54) **SOT-MRAM MEMORY COMPRISING A CURRENT ASYMMETRY-CORRECTING MEANS**

(71) Applicant: Centre National de la Recherche Scientifique, 75016 Paris (FR)
(72) Inventor: Leroy, Fabien, 38240 MEYLAN (FR); Louche, Julien, 38240 MEYLAN (FR); Brecte, Victorien, 38240 MEYLAN (FR); Becle, Etienne, 38240 MEYLAN (FR)
(74) Representative: IPAZ

(57) **Abstract**

A SOT-MRAM memory (MEM) comprising an array (ARR) of rows and columns of cells (CELL) each comprising a tri-layer element (TLE) including a ferromagnetic pinned layer, a ferromagnetic free layer, and a spacer interposed in-between, the SOT-MRAM memory (MEM) being configured so as to correct, in operation, an asymmetry between electrical currents running through the tri-layer element and within the SOT layer, by introducing an electrical resistance between the SOT layer (SOT) and functional circuits connected to the SOT layer through a source line (SL).

## Description

### FIELD OF THE INVENTION

The technical domain of the invention is that of Magnetoresistive Random Access Memory (MRAM) cells, that each comprise an element whose magnetic state defines a bit of information, and more specifically that of MRAM bit cells making use of a layer adjacent and parallel to this element to circulate a current in order to define its magnetic state.

### BACKGROUND OF THE INVENTION

Increased densities and reduction in die areas of embedded memories for cache applications, such as SRAM (Static Random Access Memory) and eDRAM (embedded Dynamic Random Access Memory) lead to increased static power consumption and reliability issues. Alternatives emerge such as MRAMs (Magnetoresistive Random Access Memory), that are scalable, power efficient and fast enough to replace existing memory technologies (SRAM) at cache levels.

MRAMs are devices able to store bits of data by means of magnetization state in tri-layer elements comprising a stack of two ferromagnetic layers separated by a non-magnetic spacer. When the spacer is conductive the tri-layer element is called a Spin Valve (SV) and when the spacer is insulating the tri-layer element is called a Magnetic Tunnel Junction (MTJ). The resistance of the tri-layer element (TLE) to electrical current passage is governed by quantum mechanical physics.

One of the two ferromagnetic layer has a pinned (or fixed) magnetization while the other one has a magnetization that can be oriented, and they are therefore often referred to as the pinned ferromagnetic layer (or fixed ferromagnetic layer, or also reference ferromagnetic layer) and the ferromagnetic free layer, respectively.

In an actual device, a tri-layer element (TLE) comprises other layers in addition to those cited so far, used to improve control over the physical properties of the device and/or inject currents therein and/or that are necessary for its manufacturing process.

A tri-layer element (TLE) exhibits two equilibrium states: a low-resistance state in which magnetizations of the two ferromagnetic layers are in a parallel state, i.e. magnetizations of both ferromagnetic layers are oriented towards a same direction, and a high-resistance state in which magnetizations of the two ferromagnetic layers are in an antiparallel state, i.e. magnetizations of the two ferromagnetic layers are respectively oriented towards two opposite directions.

An MRAM memory array comprises MRAM memory cells juxtaposed so as to form an array of rows and columns, each of the memory cells comprising a tri-layer element in which these two states and their corresponding electrical resistance values are associated to bit values, "0" or "1". These bit values are read by flowing an electrical current through the two ferroelectric layers of the tri-layer element (TLE) to determine its electrical resistance value, associated to a recorded bit value.

The ferromagnetic pinned layer is used as a reference ferromagnetic layer and its magnetization is stable over the lifetime of the device. The ferromagnetic free layer can be written (i.e. its magnetization orientation can be controlled) at will by application of a current or a magnetic field.

Regarding the write mechanism, one may cite three types of MRAMs each based on a specific mechanism for writing the state of the ferromagnetic free layer: Field switching MRAM relying of a magnetic field, Spin-Transfer Torque MRAM (STT-MRAM) relying on spin-transfer torque mechanism, and Spin Orbit Torque MRAM (SOT-MRAM) relying on spin orbit torque mechanism.

A SOT-MRAM bit cell, where SOT stands for Spin Orbit Torque, is a three-terminal memory cell comprising a SOT layer usually made of a heavy metal, adjacent to the free ferromagnetic layer of one tri layer element. The magnetization of the free ferromagnetic layer is controlled by circulating an electric current within the SOT layer by spin orbit torque interaction, optionally in combination with an electric current crossing perpendicularly the three layers of the tri-layer element in the case of an STT-assisted SOT-MRAM bit cell that combines the Spin-Transfer Torque and the Spin Orbit Torque writing mechanisms.

In many implementations, each MRAM memory cell of an MRAM array comprises a single transistor having a source or a drain connected to only one side of the SOT layer, in order to select cells when writing and reading information by allowing current to flow through the cell. This structure results in an asymmetry at the level of the SOT layer, occurring when a current is to run through the three layers of the tri-layer element: since the internal resistance to electrical current of the transistor is much higher than the resistance of the simple conducting line on the other side of the SOT layer, much less current will flow on the side of the SOT layer to which the transistor is connected than on the opposite side of the SOT layer.

Due to this imbalance in the SOT current flow, there is a probability that the SOT effect writes the free layer in a way that is not expected, resulting in read disturb fails during read operation or affecting the write error rate during write operation known as write fails.

### OBJECT OF THE INVENTION

In the context described above, the inventors propose to reduce the write fails occurring in a SOT-MRAM by balancing the currents on both sides of the SOT layer in each bit cell of a SOT-MRAM in the case where a current is flowing through the tri-layer element.

### SUMMARY OF THE INVENTION

To this effect, a first aspect of the invention relates to a SOT-MRAM memory comprising an array of rows and columns of SOT-MRAM bit cells each comprising a tri-layer element including a ferromagnetic pinned layer, a ferromagnetic free layer, and a spacer interposed in-between, each of the SOT-MRAM bit cells further comprising a SOT layer adjacent to the ferromagnetic free layer and one write transistor having a source or a drain connected to a first contact region on a first side of the SOT layer, wherein, for each SOT-MRAM bit cell of a given column, a source line is connected to a second contact region on a second side of the SOT layer opposite to the first side of the SOT layer, so that the SOT layer is interposed between the write transistor and the source line, and wherein the SOT-MRAM memory is configured so as to correct at least partially, in operation, an asymmetry between electrical currents running in the SOT layer through the first contact region and through the second contact region, by means of an element having an electrical resistance connected to the second side of the SOT layer.

The SOT-MRAM memories according to the invention allows for a better reliability during read and write operations of the bit cells, by correcting the asymmetry of electrical currents flowing through the SOT layer.

According to further non limitative features of the first aspect of the invention, either taken alone or in any technically feasible combination:
- the SOT-MRAM memory further can comprise a compensation circuit configured so as to present, in operation, an electrical resistance representative of an electrical resistance of the write transistor of a selected one of the SOT-MRAM bit cells, the SOT layer of the selected one of the SOT-MRAM bit cells being connected to a block of functional circuits through the source line in series with the compensation circuit;
- the compensation circuit can comprise at least two branches each connectable to the SOT line and configured to present, in operation, an electrical resistance representative of the electrical resistance of the write transistor of the selected one of the SOT-MRAM bit cells during a respective one of two distinct operations on the selected one of the SOT-MRAM bit cells;
- the two distinct operations can be chosen among a SOT write operation and a read operation and, when the SOT-MRAM bit cells are STT-assisted SOT-MRAM bit cells, a first STT write operation and a second STT write operation ;
- the compensation circuit can comprise at least one compensation transistor controlled by a compensation voltage and configured to present the electrical resistance representative of the electrical resistance of the write transistor of the selected one of the SOT-MRAM bit cells;
- each of the at least two branches can comprise a respective compensation transistor controlled by a compensation voltage and configured to present the electrical resistance representative of the electrical resistance of the write transistor of the selected one of the SOT-MRAM bit cells;
- the compensation circuit can be configured so that the compensation voltage is, in operation, representative of a voltage applied to a gate of the write transistor (Tr_{w}) of the selected one of the SOT-MRAM bit cells;
- the SOT-MRAM memory can further comprise a compensation voltage generating circuit configured to generate the compensation voltage as representative of a combination of i) a voltage applied to a gate of the write transistor of the selected one of the SOT-MRAM bit cells and ii) of a position of the selected one of the SOT-MRAM bit cells in the array;
- the compensation voltage generating circuit can comprise a plurality of generation transistors each belonging to one of the rows of SOT-MRAM bit cells and connected between two electrically conductive lines running in parallel to the source line, each generation transistor being controlled by a word line dedicated to a respective row of the rows of SOT-MRAM bit cells, the compensation voltage generating circuit being configured to generate the compensation voltage corresponding to the selected one of the SOT-MRAM bit cells, this compensation voltage being generated so as to make an electrical resistance of the compensation transistor match the electrical resistance of the write Transistor of the selected cell;
- the compensation circuit can comprise a plurality of branches comprising respective selection transistors, two opposite extremities of each branch being respectively connected to i) a node connectable to the sources lines via a multiplexer configured to select one of the source lines and to ii) the block of functional circuits, the SOT-MRAM memory being configured to control the selection transistors in accordance with voltages representative of a distance of a selected bit cell to the block of functional circuits;
- each of the branches can further comprise a resistor in series with a respective one of the selection transistors;
- a position of the tri-layer element along a length of the SOT layer of any given SOT-MRAM bit cell can be a function of a row to which this bit cell belongs, so as to at least partially compensate for an electrical resistance, in operation, of the write transistor of this SOT-MRAM bit cell; and
- the SOT-MRAM memory can further comprise a block of functional circuits connectable to the source line, wherein the farther a bit cell is situated from the bit line decoder, the closer the tri-layer element (TLE) is from the first side of the SOT layer.

A second aspect of the invention encompasses an integrated electronic circuit including the SOT-MRAM memory according to the first aspect of the invention.

### FIGURES

Many other features and advantages of the present invention will become apparent from reading the following detailed description, when considered in conjunction with the accompanying drawings, in which:
- Figure 1 illustrates a core of an SOT-MRAM bit cell ;
- Figure 2 illustrates a integration of the core of figure 1 into a SOT-MRAM bit cell ;
- Figure 3 illustrates a first SOT-MRAM memory including the bit cell of Figure 2 and a compensation circuit ;
- Figure 4 illustrates a specific compensation circuit ;
- Figure 5 illustrates a third SOT-MRAM memory including the bit cell of Figure 2 and a compensation voltage generating circuit ;
- Figure 6 illustrates a specific compensation circuit ;
- Figure 7 illustrates a specific compensation circuit ;
- Figure 8 illustrates an array of bit cells and the localization of a tri-layer element on a SOT layer; and
- Figure 9 illustrates electronic components including the memories of previous figures.

The figures are schematic representations that, for the sake of clarity, are not drawn to scale and, in particular, thicknesses of layers are not to scale compared to lateral dimensions.

### DETAILED DESCRIPTION OF A SPECIFIC EMBODIMENT OF THE INVENTION

### Context and issue to solve

As an applicative example of the invention, an STT-assisted SOT-MRAM bit cell according to the invention has the overall structure of an SOT-MRAM bit cell, with a tri-layer element TLE controlled by means of three electric terminals.

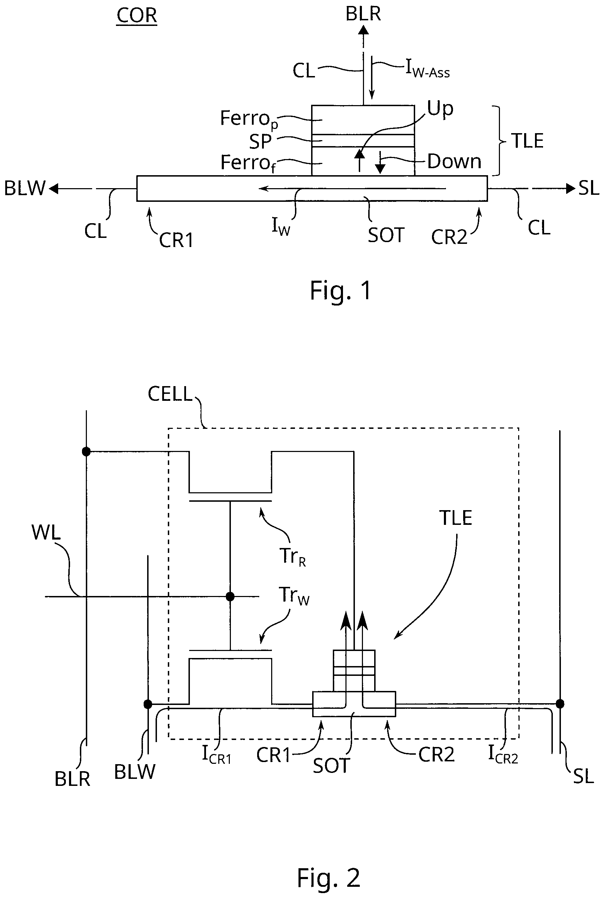

Figure 1 illustrates the core COR of the bit cell: a tri-layer element TLE comprising a ferromagnetic free layer Ferro_{f} and a pinned ferromagnetic layer Ferroₚ separated by a spacer SP, and a SOT layer SOT adjacent to the ferromagnetic free layer, this layer SOT being configured to generate a spin-orbit torque onto the spins of the free ferromagnetic layer upon circulation therein of a write current Iw. A write-assisting current, of either positive or negative value, can be injected into the tri-layer element via the pinned ferromagnetic layer Ferroₚ.

The ferromagnetic layers Ferro_{f} and Ferroₚ both present a perpendicular magnetic anisotropy (PMA), which means that their spins are naturally aligned along a direction perpendicular to the planes of extension of these layers. In contrast, "in-plane" directions refer to directions that are parallel to the extension planes of the ferromagnetic layers Ferroₚ and Ferro_{f}, i.e. normal to the natural orientation of the spins in the ferromagnetic layers Ferro_{f} and Ferroₚ. The magnetic state of the tri-layer element can be parallel (the magnetizations of the two ferromagnetic layers have a same direction) or anti-parallel (the magnetizations of the two ferromagnetic layers have opposite directions).

As illustrated in Figure 1, in a SOT-MRAM bit cell, two opposite contact regions CR1 and CR2 of the SOT layer are respectively connected to a bit line write BLW and a source line SL via two electrically conductive lines CL. The write-assisting current I_{W-Ass} being injected into the pinned ferromagnetic layer Ferroₚ originating from a bit line read BLR via a third electrically conductive line CL. The two opposite contact regions of the SOT layer can be two opposite extremities of the SOT-layer. In any event, the two opposite contact regions are localized so that a current passing through these two contact regions passes in a contact region of the SOT layer immediately adjacent to the free ferromagnetic layer and between the two opposite contact regions, so as to control the magnetic state of Ferro_{f} by spin-orbit torque mechanism. The write current I_{W} circulates between the source line SL and the bit line write BLW.

When the write operation of the magnetic state of the free ferromagnetic layer Ferro_{f} is performed by STT-assisted SOT writing, the write current I_{W} passing through the layer SOT brings the magnetization in an in-plane direction by spin-orbit torque (SOT) interaction, and the write-assisting current I_{W-Ass} current forces the direction of the magnetization into a direction perpendicular to the plane of extension of the ferromagnetic free layer by spin-transfer torque (STT) interaction, one of two opposite directions Up and Down depending on the direction of the write-assisting current I_{W-Ass,} as illustrated in figure 1. In effect, the magnetic state of tri-layer element can be transitioned between the parallel and the anti-parallel states. The patent document EP 3 671 749 B1 explains in more details the operation of STT-assisted SOT writing. Read operation is performed by applying a given potential to the line BLR and measuring the resulting current flowing through the tri-layer element TLE, this current being indicative of the parallel and the anti-parallel states of the tri-layer element, as determined by a comparison with a reference current.

Figure 2 illustrates an integration of the core COR into an STT-assisted SOT-MRAM bit cell CELL, including write and read transistors Tr_{W} and Tr_{R} and lines WL, BLR, BLW and SL employed to address and control currents running through the MRAM bit cell and the magnetic state of the free ferromagnetic layer Ferro_{f} therein.

More specifically, in this example, the read bit line BLR is connected to the pinned ferroelectric layer Ferroₚ of the tri-layer element through the source and the drain of the read transistor Tr_{R}. Also, the source line SL is connected to the write bit line BLW via the SOT layer SOT and the source and the drain of the write transistor Tr_{W}. The SOT layer is connected to the line BLW through the source and the drain of the write transistor Tr_{W}. This is equivalent to say that the source or the drain of the write transistor is connected to a first side of the SOT layer corresponding to the contact region CR1, opposite to a second side of the SOT layer corresponding to the contact region CR2 that is connected to the source line SL. The word line WL is connected to the gate electrodes of the transistors Tr_{R} and Tr_{W} so as to control their states, "ON" or "OFF".

During read and write operations, currents flow through the SOT layer between the lines SL and BLW, but also between these lines and the line BLR, on purpose, for example when using the current I_{W-Ass} to write a state of the layer Ferro_{f} or when reading the state of the bit cell, but unwanted current may also run through the tri-layer element during a phase of the STT-assisted SOT-write operation in which no Iw-Ass current circulates, or in a (non STT-assisted) SOT-write operation of a pure SOT-MRAM due to unavoidable current leaks, for example because the transistor Tr_{R} is not "off".

However, while the SOT layer is connected directly to the line SL via a conductive line CL, it is connected to the line BLW through the source and the drain of the transistor Tr_{W}, used to select the bit cell on which an operation is performed, and which brings a higher resistance to current than the conductive line. Thus, an asymmetry takes place between the intensities of current I_{CR1} and I_{CR2} flowing towards the line BLR through the SOT layer respectively from the line BLW and from the line SL.

As a consequence, there is a probability that the SOT effect writes the ferromagnetic free layer in a way that is not expected, resulting in read disturb fails during read operation or affecting the write error rate during write operation, i.e. write fails. Even though the involved currents are relatively low, they can still have a significant impact on the most sensitive cells of an array, that are prone to switch in a somewhat uncontrolled manner.

The objective of the invention is to solve or at least mitigate the effect of asymmetrical currents running through the SOT layer. This is done by introducing an element that have an electrical resistance on the side of the SOT layer opposite to the side where the write transistor is located. This electrical resistance may be a fixed electrical resistance by means of a resistor, or a variable electrical resistance, including or consisting of a contribution to electrical resistance due to one or a plurality of transistors.

### First implementation

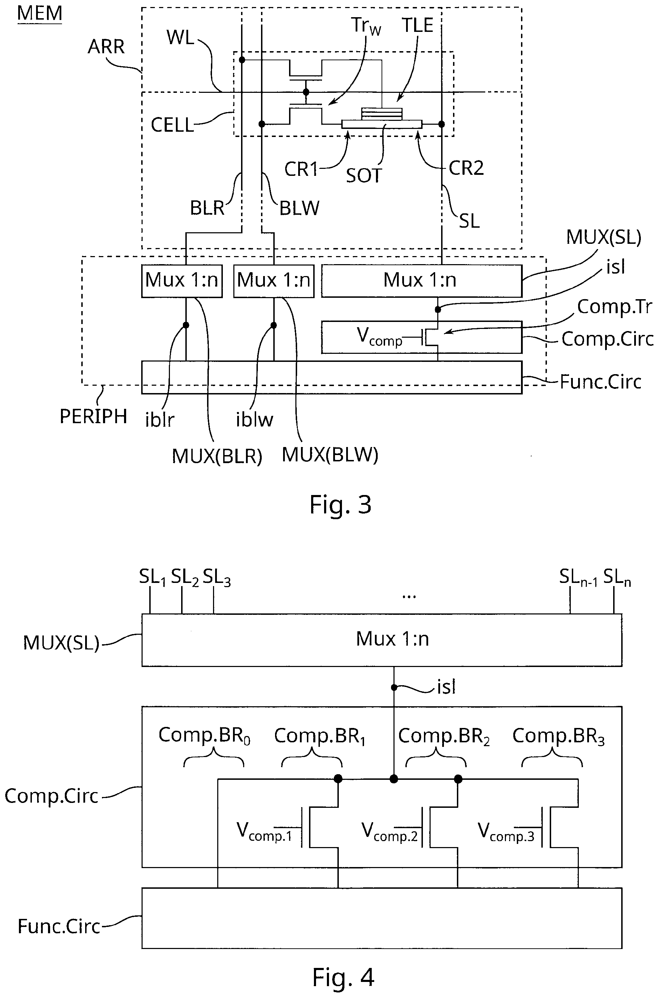

Figure 3 illustrates a SOT-MRAM memory MEM according to a first implementation of the invention, with the connections of the STT-assisted SOT-MRAM bit cell CELL of Figure 2 integrated in an array ARR of *m* rows and n columns of such bit cells connected to multiplexers MUX(SL), MUX(BLR) and MUX(BLW) in an SOT-MRAM memory MEM (only one bit cell among the *m*×*n* bit cells of the array is represented in Figure 3). The multiplexers MUX (BLR) and MUX (BLW) are configured to connect at any given instant the lines BLR and BLW, respectively, of a given one of the bit cells CELL to a respective input of a block Func.Circ of functional circuits. Similarly, the multiplexer MUX (SL) is configured to connect at any given instant the line SL of the given one of the bit cells CELL to a respective input of the block Func.Circ of functional circuits. Thus, the multiplexers each select one line among n, as denoted by the indication "Mux 1:n" of the multiplexers illustrated by the figures (for each of the multiplexers, only one of the n input lines is represented). For illustration, one may refer to Figure 4: the *n* SL lines SL1 to SLn of the n columns are connected in parallel to n entries of the multiplexer MUX(SL) that is configured to select one of these n lines for connection to a node isl that is located between the multiplexer MUX(SL) and a compensation circuit Comp.Circ, the compensation circuit being connected between the node isl and the block Func.Circ. Similarly, the n BLR lines and the n BLW lines of the n columns are connected in parallel to n entries of the multiplexers MUX(BLR) and MUX(BLW) that are each configured to select one of the corresponding n lines for connection to a node iblr and a node iblw that are located between the multiplexers MUX(BLR) and MUX (BLW) and the block Func.Circ, respectively. The lines BLR, BLW and SL are connectable to the block Func.Circ via the multiplexers MUX(BLR), MUX(BLW) and MUX(SL), respectively. The block Func.Circ comprises electronic circuits that are conventionally employed to control the array of bit cells by applying controlled voltages onto the lines BLR , BLW and SL and connecting the lines BLR or SL to a sense amplifier when reading the state of a selected bit cell.

More specifically, each bit cell CELL of a given one of the n columns is connected to a same line BLR, a same line BLW and a same line SL. Further, the lines BLR, BLW and SL are connected in parallel to the block Func.Circ of functional circuits that is configured to operate the array ARR in a conventional way. According to this first implementation of the invention, the compensation circuit Comp.Circ is interposed between the line SL and the block Func.Circ.

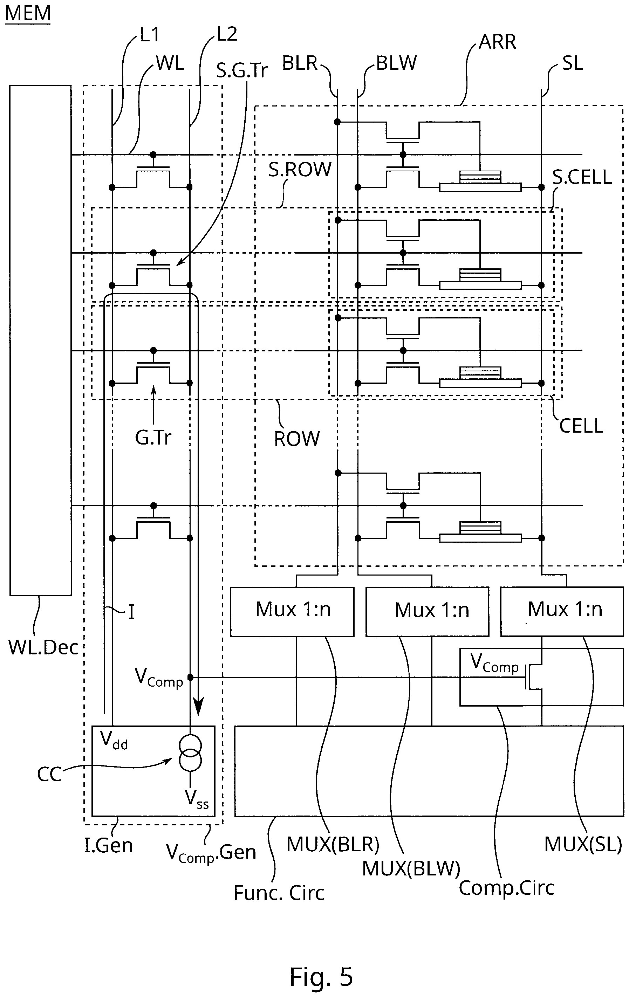

Also, although not represented in Figure 3, a word line decoder WL.Dec situated on a side of the array controls potentials applied to word lines WL connected to the rows of bit cells CELL, as illustrated in Figure 5.

The compensation circuit Comp.Circ is configured to introduce a resistance between the line SL and the block Func.Circ, and more generally between the side of the source line SL and the power source or the ground, this resistance compensating the resistance introduced by the transistor Tr_{W} in each of the bit cells of the column of bit cell connected to the line SL, so that the imbalance between currents CR1 and CR2 is lessened.

In this implementation, the compensation circuit comprises, as an element having an electrical resistance connected to a side of the SOT layer opposite to the side of the SOT layer that is connected to the write transistor Tr_{W} for each of the bit cells, a compensation transistor Comp.Tr having one of a source and a drain connected to the line SL and the other one of the source and the drain connected to the block Func.Circ, and a gate to which a compensation voltage V_{comp} is to be applied. The value of the compensation voltage can be determined by calculation so that, in operation, the resistance introduced by the transistor Comp.Tr represents an approximation of the resistance introduced by the transistor Tr_{W}.

The electrical resistance introduced by the transistor Tr_{W} is a variable electrical resistance that depends on (i) the control voltages applied to the lines WL and (ii) the voltages of the source of Tr_{W}, the source of Tr_{W} being either BLW or the SOT line which depends on BLR and SL voltages. BLW, SL and BLR voltages depend strongly on the position of the bitcell in the array, as the distances between the portions of the lines where the control voltages are applied and, respectively, the gate, the source and the drain of the transistor impact the voltages that are effectively applied to the gate, the source and the drain.

To take these effects into account, it is preferable that the voltage V_{Comp} be chosen so that the resistance introduced by the transistor Comp.Tr represents the resistance introduced by a reference transistor Tr_{W} belonging to a bit cell situated approximately in the middle of the array. More specifically, if the array comprises m rows, the reference transistor should belong to the m/2^{th} row. In this way, the average effect of the compensation for the m bit cells connected to the line SL is optimized.

Figure 3 illustrates a configuration where the compensation circuit and the block Func.Circ are located on a side of the array ARR, as peripheral circuits PERIPH. However, it is also possible to locate the compensation circuit in the middle of the array, for example close to the m/2th row, to reduce the impact of the length of the line SL. In this case, an additional line to connect the compensation circuit to the multiplexer MUX(SL) is preferably employed, so that the compensation circuit is connected between this additional line and the line SL.

### Second implementation

Figure 4 illustrates a SOT-MRAM memory MEM according to a second implementation of the invention. In the first implementation, illustrated by Figure 3, a single compensation transistor Comp.Tr is employed whatever the type of the operation that is performed on the bit cell, writing or reading. In the second implementation, the compensation circuit Comp.Circ comprises branches that are dedicated to specific operations. For the other aspects of this second implantation, one may refer to the first implementation.

In the present exemplary implementation, four branches BR₀ to BR₃ of the compensation circuit are connected to the node isl and are respectively dedicated to a SOT write operation, a first STT write operation, a second STT write operation, and a read operation. Each of these branches can be considered as an element having an electrical resistance connected to a side of the SOT layer opposite to the side of the SOT layer that is connected to the write transistor Tr_{W} for each of the bit cells. Three branches are dedicated to the write operation because a single write operation can comprise several phases, for example a pure SOT write phase and a pure STT write phase, the pure STT write phase requiring two distinct voltages (high of low) depending of the state of the free ferromagnetic layer to be written. Branches BR₀ to BR₂ allow application of high voltages Vdd or low voltages Vss for the write operations while branch BR₃ leads to a sense amplifier SA used to determine the state of the ferromagnetic free layer.

In this second implementation of the invention, the compensation circuit of Figure 4 comprises four branches, Comp.BR₀ to Comp.BR₃, connected between the node isl and the block Func.Circ. The branch BR₀, dedicated to pure SOT write operation, does not require compensation.

Each of the compensation transistors can be controlled by a specific compensation voltage V_{Comp} applied to its gate electrode, the value of the compensation voltage V_{Comp} can be adapted to the operation to which the corresponding branch is dedicated and to introduce a resistance between the line SL and the block Func.Circ, this resistance compensating the resistance introduced by the transistor Tr_{W} in each of the bit cells of connected to the line SL, so that the imbalance between currents CR1 and CR2 is lessened, as explained in the first implementation. Thus, in this example, three different compensation voltages V_{comp.1} to V_{comp.3} may be applied to the gate of the compensation transistor Comp.Tr of the respective branches Br₁ to Br₃.

Figure 4 illustrates a situation where three branches employing each a compensation transistor are used. More generally, there could be as many branches and compensation transistors as there are paths from the sot line to the power sources or the ground when having STT-assisted write or read current in the tri-layer element.

### Third implementation

Figure 5 illustrates a SOT-MRAM memory MEM according to a third implementation of the invention. The first and the second implementation can make use of a same voltage V_{Comp} regardless of the row to which belongs a bit cell that is operated. In the present implementation, the value of the compensation voltage V_{Comp} is adapted to the row to which this bit cell belongs. For the other aspects of this third implantation, one may refer to the first and the second implementations.

More specifically, the memory MEM comprises a compensation voltage generating circuit V_{Comp}.Gen that comprises a plurality of generation transistors G.Tr connected between two electrically conductive lines L1 and L2 that run in parallel to the source line SL, for example between a word line decoder WL.Dec connected to the word lines WL and the array ARR of rows and columns of bit cells. The two lines L1 and L2 are connected to a current generating circuit I.Gen comprising a source of high voltage Vdd connected to the line L1 and a constant current source CC connected to the line L2. Each transistor G.Tr belongs to one of the rows of SOT-MRAM bit cells CELL of the array ARR, and each transistor G.Tr is controlled by a word line WL dedicated to the row of cells to which it belongs, this word line being connected to the gate electrode of the transistor.

In operation, a high potential V_{dd} is applied to the line L1, a constant current is imposed to the line L2, and a bit cell S.CELL is selected, implying that a voltage turns "ON" the generation transistor S.G.Tr of the row S.ROW of the selected bit cell S.CELL, so that the current I runs through the line L1, then through the transistor S.G.Tr that introduces a variable electrical resistance dependent i) on the voltage applied to its gate electrode and ii) the position of the row S.ROW in the array which is due to the biasing of the source of the transistor that is linked itself to the electrical resistance of the line L2 between the transistor and the current generating circuit CC. The voltage of line L2 just outside of the current generating circuit is the compensation voltage V_{Comp} that can be expressed as V_{dd}-I×R(selected cell) where R(selected cell) depends on the length ran by the current I along lines L1 and L2 in addition to the resistance of the G.Tr transistor mentioned before, and thus on the localization of the selected cell S.CELL in the array ARR.

With this configuration, the compensation voltage V_{Comp} is representative of (i) the control voltages applied to the line WL of a selected cell S.CELL and (ii) the position of the selected cell S.CELL in the array.

This voltage V_{Comp} can be applied to the gate electrode of the compensation transistor Comp. Tr of the first implementation or to any of the transistors Comp.Tr of the second implementation.

### Fourth implementation

In the first to third implementations, the level of compensation is controlled by the values of the compensation voltages V_{Comp} applied to the gates of compensation transistors Comp.Tr belonging to a compensating circuit Comp.Circ. The fourth implementation proposes an alternative by providing, in the compensation circuit Comp.Circ, a set of resistors connectable to any bit cell of the array ARR via the corresponding source line SL and the multiplexer MUX(SL). The resistors have the same function as the compensation transistor of the previous implementation: compensating the resistance introduced by the transistor Tr_{W} in each of the bit cells connected to the line SL. In operation, the resistor through which the selected line SL will be connected to the block Func.Circ will depend on the position of the selected cell S.CELL in the array ARR.

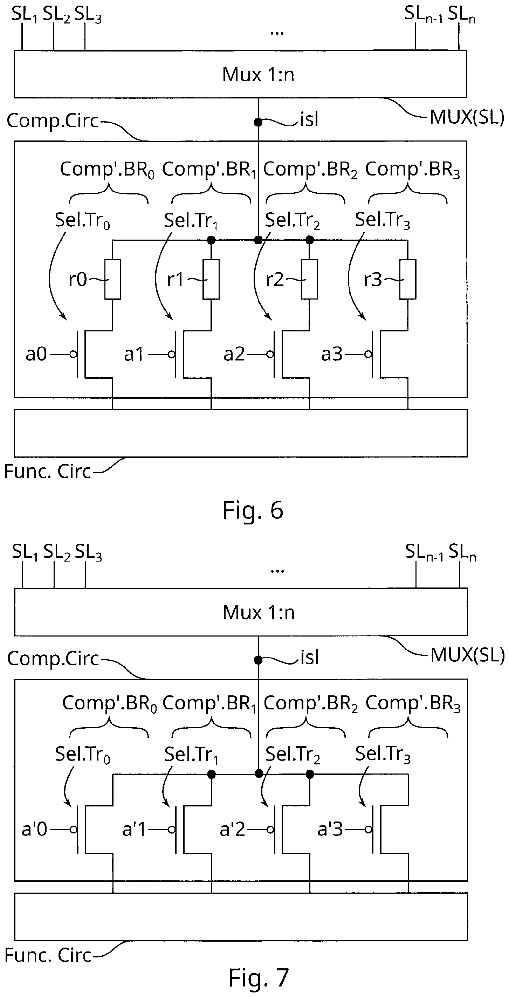

Figure 6 illustrates a SOT-MRAM memory MEM according to the fourth implementation of the invention. The compensation circuit comprises four compensation branches Comp'.Br₀ to Comp'.Br₃ with respective resistors r0 to r3 connected in series with sources and drains of respective selection transistors Sel.Tr0 to Sel.Tr3. One extremity of each branch Comp' .Br0 to Comp' .Br3 being connected to the block Func.Circ to perform a given operation on the bit cells (read, write, refer to the first implementation and Figure 4) while the opposite extremities are each connected to the node isl.

In operation, compensation voltages a0 to a3 representative of the address of a selected bit cell, and thus of the position of this bit cell in the array, are respectively applied to the gates of the selection transistors Sel.Tr0 to Sel.Tr3. For example, first to fourth groups of rows of the array may respectively correspond to one of the compensation voltages a0 to a3, the first group of rows being closer to the block Func.Circ than the second to fourth groups of rows, the second group of rows being closer to the block Func.Circ than the third and fourth groups of rows, and the third group of rows being closer to the block Func.Circ than the fourth group of rows. In this way, the current running through the source line SL will take a compensation branch depending on the distance of the selected bit cell to the block Func.Circ, and thus allows to take into account the position of the bit cell in the array to employ an adequate compensation resistance.

The values of a0 to a3 may result of the decoding of most significant address bits corresponding to row selection of the address of any given bit cell.

The applied voltages a0 to a3, the resistance values of the resistors r0 to r3 and the characteristics of the selection transistors Sel.Tr0 to Sel.Tr3 are chosen so that the electrical resistance induced by the selection transistors and the corresponding resistors present a value at least partially compensating the resistance introduced by the transistor Tr_{W} of a selected bit cell CELL.

In this example, the array is divided into four groups of rows each associated to an adapted compensation voltage, but another number of groups may be chosen.

### Fifth implementation

The fifth implementation is a variant of the fourth implementation in which, instead of using in each branch of the compensation circuit a resistor in series with a selection transistor, the selection transistor itself is configured to present a sufficient resistance, so that the resistors of the fourth implementation are not necessary.

Figure 7 illustrates a SOT-MRAM memory MEM according to the fifth implementation of the invention. It is similar to the SOT MRAM memory of Figure 6, except that each branch Comp'.BR₀ to Comp'.BR₃ comprises only a selection transistor Sel.Tr₀ to Sel.Tr₃, respectively. The gate electrodes of these selection transistors may be applied with compensation voltages V_{Comp} adapted to the position of the selected bit cell, i.e. respective voltages a'0, to a'3, as in the fourth implementation. Alternatively or simultaneously, voltages applied to the respective branches by the block Func.Circ may have values adapted to the position of the selected bit cell in the array ARR.

### Sixth implementation

The first to the fifth implementation rely on a control circuit to correct the imbalance between currents I_{CR1} and I_{CR2} due to the resistance introduced in a bit cell in operation by the write transistor Tr_{W}. The sixth implementation is an alternative that corrects locally the imbalance in the resistances on both sides of the SOT layer that appears in operation.

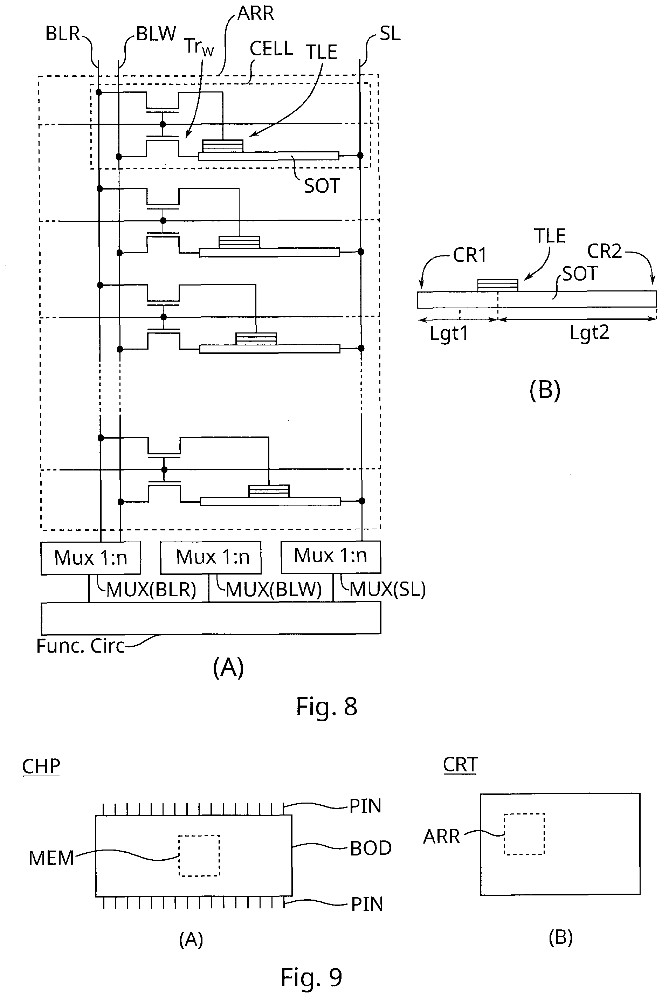

Figure 8 illustrates at (A) an array ARR of bit cells according to the present implementation and at (B) the geometry of a tri-layer element TLE on a SOT layer SOT. This implementation is based on two considerations. The first is that the resistance introduced, in operation, by the write transistor TrW, is higher the farther the concerned row is from the block Func.Circ, where control voltages are applied onto the lines BLR, BLW and SL, due to a voltage drop along of these lines caused by their respective electrical resistivities. The second is that the material constituting the SOT layer presents usually a higher electrical resistivity than connecting lines CL or SL. Thus, it is possible to position the tri-layer element on the SOT layer so as to balance at least partially the resistivity seen on each side of the SOT layer.

As illustrated by Figure 8 at (A), the farther the position of a bit cell CELL from the block Func.Circ, the closer the tri-layer element is positioned to the side of the SOT layer SOT connected to the write transistor Tr_{W}. This is because the compensation needs to be stronger on rows that are far from the bit line decoder. As illustrated at (B) of Figure 8, the compensation resistance introduced by voluntarily not centering the tri-layer element on the SOT layer will be approximatively proportional to Lgt2-Lgt1, where Lgt1 and Lgt2 represent the distances between the center of the tri-layer element TLE and, respectively, the edges of the SOT layer corresponding to the contact regions CR1 and CR2. The bigger is Lgt2, the stronger the compensation. The length Lgt2-Lgt1 of SOT layer can be considered as an element having a fixed electrical resistance, a resistor, connected to a side of the SOT layer opposite to the side of the SOT layer connected to the write transistor Tr_{W} of the bit cell. Otherwise stated, the farther a bit cell is situated from the block Func.Circ, the closer the tri-layer element is from the side of the SOT layer connected to the write transistor. The position of the tri-layer element along the length of the SOT layer of any given SOT-RAM bit cell is a function of a row to which this bit cell belongs, this position being calculated so as to at least partially compensate for an electrical resistance, in operation, of the write transistor Tr_{W} of this SOT-MRAM bit cell.

Figure 9 illustrates at (A) a standalone memory chip CHP including any one of the SOT-MRAM memories MEM according to the first to sixth implementations encapsulated within a body BOD, a plurality of connecting pins PIN fixed to the body allowing functional access to the MRAM bit cell array ARR from the outside of the body.

Figure 9 illustrates at (B) an integrated electronic circuit CRT, such as an ASIC circuit, integrating any one of the SOT-MRAM memories MEM according to the first to sixth implementations.

The implementations and examples mentioned in this document can be freely combined within technical limits understood by the practitioner in the field of the invention.

Other variations to the disclosed implementations can be understood and effected by those skilled in the art in practicing the claimed invention, from a study of the drawings, the disclosure, and the appended claims.

## Claims

1. A SOT-MRAM memory (MEM) comprising an array (ARR) of rows and columns of SOT-MRAM bit cells (CELL, S.CELL) each comprising a tri-layer element (TLE) including a ferromagnetic pinned layer (Ferroₚ), a ferromagnetic free layer (Ferro_{f}), and a spacer (SP) interposed in-between, each of the SOT-MRAM bit cells (CELL) further comprising a SOT layer (SOT) adjacent to the ferromagnetic free layer (Ferro_{f}) and one write transistor (Tr_{W}) having a source or a drain connected to a first contact region (CR1) on a first side of the SOT layer (SOT),
wherein, for each SOT-MRAM bit cell (CELL) of a given column, a source line (SL) is connected to a second contact region (CR2) on a second side of the SOT layer opposite to the first side of the SOT layer, so that the SOT layer (SOT) is interposed between the write transistor (Tr_{W}) and the source line (SL), and
wherein the SOT-MRAM memory (MEM) is configured so as to correct at least partially, in operation, an asymmetry between electrical currents running in the SOT layer through the first contact region (CR1) and through the second contact region (CR2), by means of an element having an electrical resistance connected to the second side of the SOT layer (SOT).

2. A SOT-MRAM memory (MEM) according to claim 1, wherein the SOT-MRAM memory (MEM) further comprises a compensation circuit (Comp.Circ) configured so as to present, in operation, an electrical resistance representative of an electrical resistance of the write transistor (Tr_{W}) of a selected one of the SOT-MRAM bit cells (S.CELL), the SOT layer (SOT) of the selected one of the SOT-MRAM bit cells (S.CELL) being connected to a block (Func.Circ) of functional circuits through the source line (SL) in series with the compensation circuit (Comp.Circ).

3. A SOT-MRAM memory (MEM) according to claim 2, wherein the compensation circuit (Comp.Circ) comprises at least two branches (Comp.BR₁, Comp.BR₂, Comp.BR₃) each connectable to the SOT line (SOT) and configured to present, in operation, an electrical resistance representative of the electrical resistance of the write transistor (Tr_{W}) of the selected one of the SOT-MRAM bit cells (S.CELL) during a respective one of two distinct operations on the selected one of the SOT-MRAM bit cells (S.CELL).

4. A SOT-MRAM memory (MEM) according to claim 3, wherein the two distinct operations are chosen among a SOT write operation and a read operation and, when the SOT-MRAM bit cells (CELL) are STT-assisted SOT-MRAM bit cells, a first STT write operation and a second STT write operation.

5. A SOT-MRAM memory (MEM) according to any one of claims 2 to 4, wherein the compensation circuit (Comp.Circ) comprises at least one compensation transistor (Comp.Tr) controlled by a compensation voltage (V_{comp}) and configured to present the electrical resistance representative of the electrical resistance of the write transistor (Tr_{W}) of the selected one of the SOT-MRAM bit cells (S.CELL).

6. A SOT-MRAM memory (MEM) according to any one of claims 3 to 4, wherein each of the at least two branches (Comp.BR₁, Comp.BR₂, Comp.BR₃) comprises a respective compensation transistor (Comp.Tr) controlled by a compensation voltage (V_{comp}) and configured to present the electrical resistance representative of the electrical resistance of the write transistor (Tr_{W}) of the selected one of the SOT-MRAM bit cells (S.CELL).

7. A SOT-MRAM memory (MEM) according to any one of claim 4 to claim 6, the compensation circuit (Comp.Circ) being configured so that the compensation voltage (V_{Comp}) is, in operation, representative of a voltage applied to a gate of the write transistor (Tr_{W}) of the selected one of the SOT-MRAM bit cells (S.CELL).

8. A SOT-MRAM memory (MEM) according to any one of claim 4 to claim 7, further comprising a compensation voltage generating circuit (V_{Comp}.GEN) configured to generate the compensation voltage (V_{Comp}) as representative of a combination of i) a voltage applied to a gate of the write transistor (Tr_{W}) of the selected one of the SOT-MRAM bit cells (S.CELL) and ii) of a position of the selected one of the SOT-MRAM bit cells (S.CELL) in the array (ARR).

9. A SOT-MRAM memory (MEM) according to claim 8, wherein the compensation voltage generating circuit (V_{Comp}.Gen) comprises a plurality of generation transistors (G.Tr) each belonging to one of the rows of SOT-MRAM bit cells (CELL) and connected between two electrically conductive lines (L1, L2) running in parallel to the source line (SL), each generation transistor (G.Tr) being controlled by a word line (WL) dedicated to a respective row of the rows of SOT-MRAM bit cells (CELL), the compensation voltage generating circuit (V_{Comp}.Gen) being configured to generate the compensation voltage (V_{Comp}) corresponding to the selected one (S.CELL) of the SOT-MRAM bit cells (CELL), this compensation voltage (V_{Comp}) being generated so as to make an electrical resistance of the compensation transistor (Comp.Tr) match the electrical resistance of the write Transistor (Trw) of the selected cell (S.CELL).

10. A SOT-MRAM memory (MEM) according to any one of claims 2 to 4, wherein the compensation circuit comprises a plurality of branches (Comp'.Br0, Comp'.Br1, Comp'.Br2, Comp'.Br3) comprising respective selection transistors (Sel.Tr0, Sel.Tr1, Sel.Tr2, Sel.Tr3), two opposite extremities of each branch being respectively connected to i) a node (isl) connectable to the sources lines (SL) via a multiplexer (MUX(SL)) configured to select one of the source lines (SL) and to ii) the block (Func.Circ) of functional circuits, the SOT-MRAM memory (MEM) being configured to control the selection transistors in accordance with voltages (a0, a1, a2, a3) representative of a distance of a selected bit cell (S.CELL) to the block (Func.Circ) of functional circuits.

11. A SOT-MRAM memory (MEM) according to claim 10, wherein each of the branches further comprises a resistor (r0, r1, r2, r3) in series with a respective one of the selection transistors (Sel.Tr₀, Sel.Tr₁, Sel.Tr₂, Sel.Tr₃).

12. A SOT-MRAM memory (MEM) according to claim 1, wherein a position of the tri-layer element (TLE) along a length of the SOT layer (SOT) of any given SOT-MRAM bit cell is a function of a row to which this bit cell belongs, so as to at least partially compensate for an electrical resistance, in operation, of the write transistor (Tr_{w}) of this SOT-MRAM bit cell.

13. A SOT-MRAM memory (MEM) according to claim 12, further comprising a block (Func.Circ) of functional circuits connectable to the source line (SL), wherein the farther a bit cell (CELL) is situated from the bit line decoder, the closer the tri-layer element (TLE) is from the first side of the SOT layer (SOT).

14. An integrated electronic circuit (CHP, CRT) including the SOT-MRAM memory (MEM) according to any one of claims 1 to 13.
